# DEMANDE DE BREVET EUROPEEN

(11) **EP 0 543 699 A1**
(43) Date de publication de la demande: **26.05.1993**
(21) Numéro de dépôt: 92403024.0
(22) Date de dépôt: 10.11.1992
(51) Int. Cl.: H01L 27/15, H01S 3/25

(54) **Circuit intégré de lasers semiconducteurs et procédé de réalisation de ce circuit**

(30) Priorité: 22.11.1991 FR 9114401
(71) Demandeur: THOMSON HYBRIDES, F-92800 Puteaux (FR)
(72) Inventeur: Groussin, Bernard, F-92402 Courbevoie Cedex (FR)
(74) Mandataire: Guérin, Michel

(57) **Abrégé**

L'invention concerne les circuits intégrés de lasers, dans lesquels des barrettes (30) de lasers sont alimentées en série, avec retour du courant par le substrat.

Lorsque le substrat (27) est semi-isolant, seule la première couche épitaxiée (40) est conductrice. Pour diminuer sa résistance électrique, une pellicule superficielle (51) du substrat est rendue conductrice par diffusion d'un agent dopant.

Application aux lasers semiconducteurs de puissance.

## Description

La présente invention concerne un circuit intégré comportant au moins une barrette de diodes lasers, dont le substrat est modifié afin d'améliorer l'alimentation en courant des lasers semiconducteurs. L'invention concerne également le procédé de modification du substrat de ce circuit intégré de lasers.

L'alimentation en courant des lasers semiconducteurs pris isolément ou en groupe sur une barrette, qui en comprend jusqu'à une trentaine, ne pose pas de problèmes particuliers, parce que le courant peut passer par le substrat dopé, donc conducteur. Dans ce cas, l'alimentation électrique est appliquée sur les deux faces supérieure et inférieure du laser ou de la barrette.

Il n'en est pas de même dans le cas des circuits intégrés de lasers dont le substrat supporte une pluralité de barrettes de lasers alternées avec une pluralité de réglettes de réflecteurs. Un tel circuit intégré est décrit dans la demande de brevet français n° 88 14799 du 15 novembre 1988. Dans ces circuits intégrés, les lasers d'une même barrette sont alimentés en parallèle, mais les barrettes sont alimentées en série, par des métallisations qui courent en surface des couches semiconductrices. Ce type d'alimentation en parallèle/série est préférable parce qu'il est plus facile de réguler une moyenne intensité sous une moyenne tension qu'une forte intensité sous une faible tension : par exemple 15 A sous 66 V plutôt que 500 A sous 2 V. De ce fait, le substrat du circuit intégré est préférentiellement semi-isolant, sinon il court-circuiterait les barrettes en série.

Le courant est appliqué sur les barrettes de lasers par une première métallisation, sur la face supérieure, mais le circuit est bouclé par une couche conductrice, par exemple en n GaAs, épitaxiée sur le substrat semi-isolant, en liaison électrique avec une seconde métallisation. Pour débiter le courant nécessaire, il faut que cette couche conductrice soit épaisse, or elle est épitaxiée et ne peut pas dépasser environ 5 microns en épaisseur. En effet, la structure des différentes couches qui sont épitaxiées sur le substrat pour réaliser un circuit intégré de lasers atteint 13 microns d'épaisseur, ce qui est considérable. Epitaxier sur une plus grande épaisseur entraînerait une dégradation de la bonne qualité cristallographique.

D'autre part, cette couche conductrice en n GaAs, dopée à 2.10¹⁸ a.cm⁻³ et ayant une épaisseur de 5 microns a une résistance électrique de l'ordre de 4 ohms : il est souhaitable de pouvoir diminuer sa résistance.

L'invention apporte une solution à ces problèmes et permet d'obtenir sur un substrat semi-isolant une couche conductrice épaisse et de faible résistance électrique, sans dégrader la qualité cristallographique de la structure. Ceci est obtenu par une diffusion thermique ou une implantation en vue de doper le substrat en surface pour le rendre conducteur sur une épaisseur donnée, sans altérer sa cristallographie de monocristal. Après cette modification du substrat, les couches constitutives des lasers sont épitaxiées, normalement, dans des limites d'épaisseurs qui ne dégradent pas la cristallographie.

De façon plus précise, l'invention concerne un circuit intégré de lasers semiconducteurs, comportant au moins une barrette de lasers formés par une pluralité de couches épitaxiées sur un substrat semi-isolant, ces lasers étant alimentés en courant verticalement entre un premier contact métallique déposé sur ladite barrette et un second contact métallique pris sur la première couche conductrice épitaxiée sur le substrat, ce circuit intégré étant caractérisé en ce que, en vue d'abaisser la résistance de la première couche épitaxiée, une couche superficielle du substrat au contact de ladite première couche est rendue conductrice par diffusion de produit dopant.

L'invention sera mieux comprise par la description suivante d'un exemple d'application, appuyée sur les figures jointes en annexe, qui représentent :
- figure 1 : vue dans l'espace d'un circuit intégré selon lasers, selon l'invention,
- figure 2 : schéma structural des couches de matériaux semiconducteurs d'un laser élémentaire, selon l'invention,
- figure 3 : vue partielle d'un circuit intégré selon l'invention, agrandie de façon à en montrer le détail.

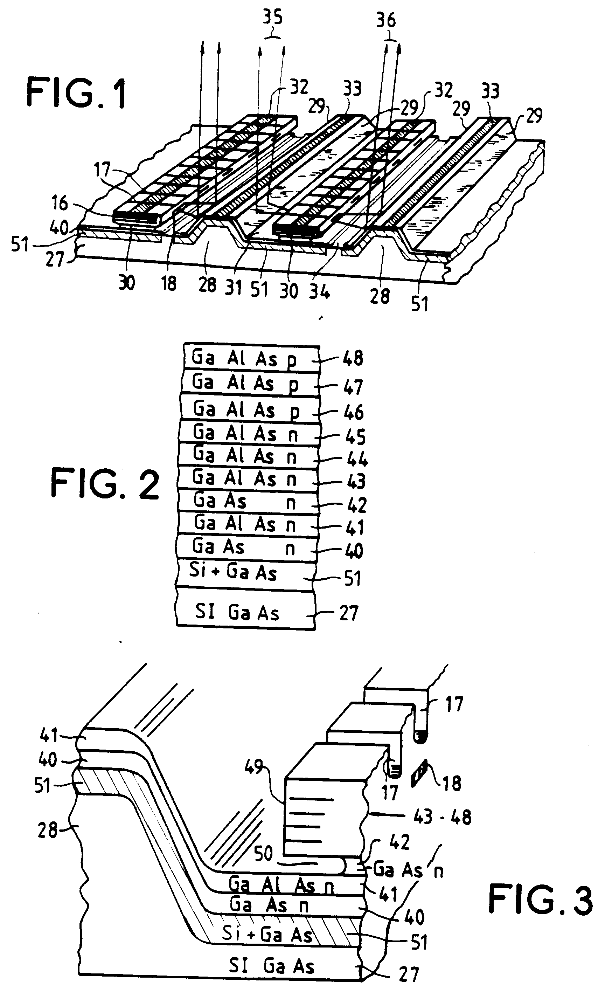

La figure 1 représente une vue de trois quart d'un circuit intégré de laser décrit dans la demande de brevet précédemment citée, mais modifiée selon l'invention. Toutefois, de façon à faciliter la comparaison, les indices de repères de la demande n° 88 14799 sont conservés.

Un circuit intégré selon l'invention comporte un substrat 27 en matériaux de la famille III-V : pour simplifier l'exposé, on admettra que le substrat est en Ga As semi-isolant. Dans ce substrat 27 sont taillés des réflecteurs 28, qui se présentent comme des réglettes parallèles entre elles, de section trapézoïdale, avec des cotés inclinés à 45°, ou de section semi-circulaire. Au moins les flancs 29 de ces réglettes sont métallisés, à la fois pour en faire des miroirs plans inclinés à 45° ou semi-cylindriques, et pour conduire le courant.

Entre les réglettes réflectrices sont disposées les barrettes 30 de lasers semiconducteurs. Chaque barrette comprend, réalisées par une suite d'épitaxiée, une pluralité de couches de matériaux semiconducteurs, repérées en 16 et détaillées en figure 2. Dans ces couches sont gravés par usinage ionique une pluralité de sillons 17, parallèles entre eux mais perpendiculaires à l'axe longitudinal de chaque barrette 30 : pris deux par deux, ces sillons 17 définissent les rubans émetteurs 18 de chaque laser élémentaire.

De la série de couches épitaxiées 16, au moins la première couche 40 déposée, dopée donc conductrice, recouvre le substrat semi-isolant 27, sur sa surface libre 31 et sur les flancs 29 des réglettes 28 de réflecteurs.

Une métallisation 32 court sur la face supérieure, libre, de chaque barrette de lasers 30, et une métallisation 33 court sur la face supérieure de chaque réglette 28 de réflecteurs : ces deux métallisations 32 et 31 permettent, en liaison avec la couche conductrice épitaxiée 40, d'alimenter en courant les lasers élémentaires.

Lorsque le circuit intégré est mis sous tension, chaque laser élémentaire émet par son ruban 18 un faisceau de lumière cohérente 35 par une face clivée et un faisceau 36 par l'autre face clivée. Ces deux faisceaux sont réfléchis sensiblement perpendiculairement au plan général du circuit intégré par les flancs métallisés 29 des réglettes 28 du réflecteurs. L'ensemble du circuit intégré émet donc une pluralité de faisceaux 35-36, parallèles entre eux et perpendiculaires au plan du substrat.

L'alimentation électrique d'un laser se fait depuis la métallisation 32, à travers les couches conductrices 48 à 42, avec retour à la métallisation 33 par l'intermédiaire des couches 41 et 40 sur les flancs 29 des réflecteurs et dans l'espace. Pour que les barrettes d'un circuit intégré ne soient pas court-circuitées entre elles par la couche conductrice 40 + 41, lorsqu'elles sont alimentées en série, une gravure 34, ou une zone isolante comparable, est pratiquée soit sur la surface libre 31, soit sur une barrette 28 de réflecteurs, de façon à rompre la continuité électrique en surface sur circuit intégré.

On voit que le courant qui traverse verticalement une barrette 30 de lasers est rebouclé par une ou deux couches de matériaux conducteurs.

Or ces couches ne peuvent pas être très épaisses parce qu'elles sont épitaxiées. La figure 2 donne le détail des couches nécessaires pour un circuit intégré de lasers.

Sur le substrat semi-isolant sont superposées :
- une couche 40 conductrice, de 2 à 5 µm d'épaisseur, en GaAs,
- une couche 41 en GaAlAs qui est une couche d'arrêt de la gravure chimique d'un porte-à-faux 50 dans une couche 42 en GaAs, nécessaire aux faces clivées des lasers,
- une pluralité de couches 43 à 47, toutes en GaAlAs, qui définissent un puits quantiques 45,
- une couche 48 de prise de contact électrique en GaAlAs.

Toutes ces couches atteignent environ 13 micromètres d'épaisseur, et il n'est pas possible d'augmenter considérablement l'épaisseur de la couche 40 pour en diminuer la résistance électrique, en raison du trop grand risque de destruction de l'équilibre cristallographique.

La solution proposée par l'invention consiste, sans aucune modification de la structure épitaxiée nécessaire, à rendre conductrice une partie du substrat semi-isolant 27, au moyen d'une diffusion de silicium Si dans une couche superficielle 51 du substrat, et bien entendu du côté du substrat qui supporte les couches épitaxiées. L'implantation de silicium est une solution possible mais elle dégrade le réseau cristallin du substrat, tandis qu'une diffusion ne la détruit pas, et permet d'édifier par la suite la structure épitaxiée décrite ci-dessus.

La figure 3 montre un agrandissement de la région commune aux barrettes de lasers et aux réglettes de réflecteurs, dans laquelle les couches épitaxiées 40 à 48 sont établies sur la couche diffusée 51.

Le produit diffusé dans le substrat peut être différent du silicium : celui-ci a été cité parce que c'est le plus couramment utilisé pour doper de type n le le GaAs. Tout produit dopant, de préférence de type n, un substrat utilisé en optoélectronique répond au critère de l'invention.

La couche 51 dopée par diffusion a une épaisseur de plusieurs microns, typiquement 2 à 5 µm. De même que la couche conductrice 40 épitaxiée, cette couche 51 diffusée est interrompue à l'aplomb des gravures 34 pour éviter de court-circuiter les barrettes de lasers 30 si elles sont alimenter en série. Elle est réalisée par le procédé décrit maintenant.

La première étape d'un procédé de fabrication collective consiste à graver par solution chimique les tranches de substrat semi-isolant, GaAs par exemple, pour former les réglettes 28 de réflecteurs. La technique utilisée est connue, et décrite dans le brevet cité.

Ensuite, une pellicule de silicium de 0,05 à 0,1 micron est déposée sur le substrat, par évaporation ou pulvérisation cathodique, et cette pellicule de silicium est encapsulée sous une pellicule étanche de silice ou de nitrure de silicium, déposée par plasma CVD, sous une épaisseur de l'ordre de 0,1 micron. L'encapsulation est nécessaire pour pouvoir chauffer une tranche de GaAs sans évaporer l'arsénic.

La diffusion thermique du silicium dans GaAs est faite en ampoule scellée, pendant 10 heures à une température comprise entre 650° et 1000° C.

Aprés la diffusion, l'enveloppe de silice ou de nitrure est retirée par attaque chimique ou plasma RIE, et la surface de la tranche de substrat est régénérée, nettoyée, par une attaque chimique qui la décape sur environ 0,1 micron.

Sur ce substrat semi-isolant mais rendu conducteur en surface par la couche diffusée 51, les opérations d'épitaxie décrites dans le brevet cité sont entreprises pour mener à bien la réalisation des barrettes de lasers 30 et des réglettes de réflecteurs 28-29.

Ce procédé de modification de substrat est utilisé pour réaliser des circuits intégrés de lasers émettant une très grande puissance optique.

## Revendications

1. Circuit intégré de lasers semiconducteurs, comportant au moins une barrette de lasers (30) formés par une pluralité de couches épitaxiées (40-48), sur un substrat semi-isolant (27), ces lasers étant alimentés en courant verticalement entre un premier contact métallique (32) déposé sur ladite barrette (30) et un second contact métallique (33) pris suer la première couche (40) conductrice épitaxiée sur le substrat (27), ce circuit intégré étant caractérisé en ce que, en vue d'abaisser la résistance de la première couche (40) épitaxiée, une couche superficielle (51) du substrat (27) au contact de ladite première couche est rendue conductrice par diffusion de produit dopant.

2. Circuit intégré selon la revendication 1, caractérisé en ce que le substrat (27) est en arséniure de gallium GaAs semi-isolant, et le produit dopant diffusé dans la couche superficielle (51) est le silicium.

3. Circuit intégré selon la revendication 1, caractérisé en ce que, si au moins deux barrettes de laser (30) sont alimentées en courant en série, la première couche (40) épitaxiée et la couche superficielle (51) diffusée sont interrompues par une gravure (14) située entre les deux barrettes (30).

4. Procédé de réalisation d'un circuit intégré de lasers sur un substrat semi-isolant, caractérisé en ce qu'il comporte les étapes suivantes :
a) - gravure chimique de la surface du substrat (27) qui porte les barrettes de lasers (30),
b) - dépôt par évaporation ou pulvérisation cathodique d'une pellicule d'agent dopant, sur le substrat,
c) - encapsulation du substrat et de la pellicule d'agent dopant par une pellicule étanche,
d) - diffusion thermique en ampoule scellée de l'agent dopant dans le substrat,
e) - suppression de la pellicule étanche par attaque chimique ou gravure RIE,
f) - régénération de la surface du substrat par attaque chimique,
g) - dépôt des couches de matériaux semiconducteur (40-48) par croissance épitaxiale sur la couche diffusée (51), conductrice, du substrat semi-isolant.

5. Procédé selon la revendication 4, caractérisé en ce que :
- le substrat semi-isolant (27) est en GaAs,
- l'agent dopant est le silicium,
- le produit d'encapsulation est la silice ou le nitrure de silicium,
- la diffusion a lieu entre 650° C et 1000° C, pendant 10 heures.
